Europäisches Patentamt

European Patent Office

Office européen des brevets

(11) Numéro de publication: **0 348 264**
**A1**

## (12) DEMANDE DE BREVET EUROPEEN

(21) Numéro de dépôt: **89401610.4**

(22) Date de dépôt: **09.06.89**

(51) Int. Cl.⁴: **H 01 L 27/14**
**H 04 N 3/15, H 01 L 21/82**

(30) Priorité: **24.06.88 FR 8808520**

(43) Date de publication de la demande:
**27.12.89 Bulletin 89/52**

(84) Etats contractants désignés: **DE FR GB IT NL**

(71) Demandeur: **THOMSON-CSF**
**51, Esplanade du Général de Gaulle**
**F-92800 Puteaux (FR)**

(72) Inventeur: **Thenoz, Yves**
**THOMSON-CSF SCPI CEDEX 67**
**F-92045 Paris la Défense (FR)**

**Roy, François**
**THOMSON-CSF SCPI CEDEX 67**
**F-92045 Paris la Défense (FR)**

(74) Mandataire: **Guérin, Michel et al**
**THOMSON-CSF SCPI**
**F-92045 PARIS LA DEFENSE CEDEX 67 (FR)**

(54) **Matrice photosensible à transfert de trame D.T.C., avec un système anti-éblouissement vertical, et procédé de fabrication d'une telle matrice.**

(57) La matrice photosensible (1) comporte, classiquement, un substrat semiconducteur (2) de type P, une couche de canal (4) de type N séparée par des zones étroites d'isolement (41) en une pluralité de colonnes (40), et sur une couche mince d'oxyde isolant (5) placée sur la couche de canal (4), un réseau (6) de grilles de transfert étendues perpendiculairement aux zones d'isolement (41) divisant les colonnes (40) en une multiplicité de "pixels". Selon l'invention, la matrice (1) comporte, entre le substrat (2) et la couche de canal (4), une couche de base (3) de type P faiblement dopée dans laquelle sont enterrées des diodes d'anti-éblouissement composées d'un drain (32) de type N fortement dopé, étroit et étendu parallèlement aux zones d'isolement (41). Sous le drain (32) est constitué un écran de protection (33) de type P fortement dopé. La disposition procure une ouverture optique de la matrice voisine de 1, et un rendu spectral amélioré vers le rouge, grâce à l'épaisseur de la couche de base (3).

FIG.1

## Description

### Matrice photosensible à transfert de trame D.T.C., avec un système anti-éblouissement vertical, et procédé de fabrication d'une telle matrice

L'invention se rapporte à une matrice à analyse de trame par transfert de charge (D.T.C.) dotée de moyens d'anti-éblouissement de genre vertical, avec, sur un substrat semi-conducteur de premier type une couche de canal de second type séparée par des zones étroites d'isolement en une pluralité de colonnes et surmontée, avec interposition d'une couche d'oxyde isolant, d'un réseau de grilles de transfert étendues perpendiculairement aux zones d'isolement et divisant les colonnes en une multiplicité de "pixels", ou unités élémentaires d'image.

L'invention se rapporte également à un procédé de fabrication d'une telle matrice photosensible.

Comme il est bien connu, ces matrices photosensibles sont destinées à transformer une image optique projetée sur la face d'entrée de la matrice en signal électrique constitué d'une séquence double de lignes et de trames. Chaque trame comprend une période d'accumulation au cours de laquelle des photons absorbés donnent naissance à des paires électrons-trous, un type de charge s'accumulant dans des cellules unitaires tandis que l'autre type de charge s'écoule à travers le semi-conducteur ; après la période d'accumulation, se place une période de transfert où les charges accumulées sont envoyées séquentiellement, par colonnes, à des capacités de conversion pour donner naissance à une tension de signal. Bien entendu la période de transfert est courte devant la période d'accumulation.

La coopération des zones d'isolement et des grilles de transfert convenablement polarisées détermine, pour chaque pixel, la formation, au cours de la période d'accumulation, de puits de potentiels discrets, séparés par des parois. Les charges s'accumulent dans ces puits, qu'elles remplissent progressivement, le courant de remplissage étant sensiblement proportionnel à l'éclairement local. Lors de la période de transfert, une modulation appropriée des potentiels de grille provoque un déplacement des parois de puits de potentiels dans la direction des colonnes, vers les capacités de conversion.

On conçoit que la capacité d'accumulation de charges des puits, conjointement avec la fréquence d'analyse de trame, détermine une gamme d'éclairements exploitable, entre un niveau d'obscurité et un niveau d'éblouissement, ce dernier correspondant au plein remplissage du puits, au-delà duquel les charges débordent au-dessus des parois et remplissant les puits adjacents.

Il est classique, pour éviter l'éblouissement de zones de la matrice par débordement des charges de puits dans les puits adjacents, de disposer des moyens d'anti-éblouissement pour drainer les charges en excédent sur un niveau de garde proche du niveau d'éblouissement, mais inférieur en valeur absolue à celui-ci. Ces moyens d'anti-éblouissement sont des diodes ou drains reliés à une connexion convenablement polarisée de façon à être bloquants pour un potentiel de puits supérieur au niveau de garde, et passants pour un potentiel inférieur, dans le cas où le substrat est de type P ; dans le cas d'un substrat de type N, les potentiels bloquant et passant sont respectivement inférieur et supérieur au niveau de garde.

Ces moyens d'anti-éblouissement, dans l'état de la technique, se classent en deux genres, horizontal ou vertical, selon que l'écoulement des charges vers les drains s'effectue parallèlement ou perpendiculairement à la surface de la matrice (considérée par convention comme étendue dans un plan horizontal).

Dans le genre horizontal, tel que décrit notamment dans les documents FR-A-2 529 388 et FR-A-2 529 390, les diodes sont disposées en surface de la matrice, adjacentes aux pixels. Il en résulte que ces diodes, qui sont inactives optiquement, occupent une surface non négligeable de la matrice ; l'ouverture optique de la matrice, ou rapport de la surface photosensible à la surface géométrique, se trouve réduite.

On a proposé également des structures anti-éblouissement du genre vertical, où les charges en excès sont évacuées à travers le substrat, par le moyen d'une jonction PN enterrée formée d'un caisson de type P dans un substrat de type N. Ces structures présentent une ouverture optique voisine de l'unité ; par contre elles entraînent une mauvaise réponse spectrale avec une perte de sensibilité pour les grandes longueurs d'onde du spectre, rouge et infrarouge. En effet la distance moyenne d'absorption des photons avec formation de paires électron-trou est relativement grande pour les photons de basse énergie dans le silicium, et excède la profondeur des caissons, celle-ci étant limitée en particulier pour que la jonction PN soit suffisamment proche du puits associé.

L'invention a pour but la réalisation d'une matrice photosensible à transfert de trame dotée de moyens d'anti-éblouissement et présentant une grande ouverture optique et une bonne réponse spectrale.

A cet effet, l'invention offre une matrice photosensible à analyse de trame par transfert de charges, dotée de moyens d'anti-éblouissement de genre vertical, avec, sur un substrat semiconducteur de premier type, une couche de canal de second type séparée par des zones étroites d'isolement en une pluralité de colonnes et surmontée, avec interposition d'une couche mince d'oxyde isolant, d'un réseau de grilles de transfert étendues perpendiculairement aux zones d'isolement et divisant les colonnes en une multiplicité de "pixels", caractérisée en ce que les moyens d'anti-éblouissement sont des diodes enterrées dans une couche de base intermédiaire entre le substrat et la couche de canal, de premier type et moins dopées que le substrat, ces diodes étant disposées en colonnes parallèles aux zones d'isolement et comportant un drain étroit de second type, fortement dopé.

Ainsi on retrouve pour l'essentiel l'avantage des moyens d'anti-éblouissement de genre vertical d'ouverture optique voisine de l'unité, les drains d'évacuation des charges en excès n'occupant pas de place en surface ; l'absorption des photons avec formation d'une paire de charges peut se faire sur toute la profondeur de la couche de base, et donc également à une profondeur supérieure à celle où sont enterrés les drains, de sorte que la réponse spectrale se rapproche de la réponse spécifique du silicium.

De préférence, chaque diode comporte un écran de protection de premier type et plus dopé que la couche de base, cet écran de protection étant adjacent au drain du côté du substrat. Cet écran fait obstacle à la collection directe des charges par le drain au cours de leur diffusion depuis le point où les photons originaires ont donné naissance à des paires électron-trou jusqu'au puits d'accumulation. On améliore ainsi encore la réponse spectrale par augmentation de l'ouverture optique pour les photons infrarouges et rouges.

Bien que l'on puisse réaliser des matrices avec des diodes d'anti-éblouissement sous une zone d'isolement sur deux, chaque diode drainant les deux colonnes adjacentes, on disposera en général une diode par colonne de la matrice. De préférence ces diodes seront disposées, en plan, entre les zones d'isolement, pour que l'évacuation se fasse par le centre des puits.

De préférence les diodes seront enterrées à une profondeur de l'ordre de la moitié de l'épaisseur de la couche de base, ce qui correspond à un compromis entre une épaisseur de couche de base suffisante pour la réponse spectrale, une profondeur de puits de potentiel convenable, et une connexion efficace des drains aux puits.

En disposition préférée, les zones d'isolement sont constituées par du semiconducteur de premier type. En effet, si ces zones d'isolement peuvent être créées par des grilles, ou formées de "LOCOS" ou zones d'oxydation locale, il est avantageux de surdoper légèrement la couche de canal de second type avec un dopant de premier type, car ces zones d'isolement sont alors photosensibles, ce qui améliore l'ouverture pour les photons du haut du spectre, qui sont absorbés près de la surface.

Bien que physiquement, le fonctionnement de la matrice soit le même, que les charges collectées dans les puits soient des électrons ou des trous, on préfère que le premier type de semiconducteur soit P et qu'ainsi les charges collectées soient des électrons, plus mobiles que les trous.

Sous un autre aspect, l'invention offre un procédé de fabrication d'une matrice photosensible à analyse de trame par transfert de charge, dotée de moyens d'anti-éblouissement du genre vertical, où, sur un substrat semiconducteur d'un premier type, l'on forme une couche de canal de second type en ménageant des zones étroites d'isolement pour diviser la couche de canal en une pluralité de colonnes, on forme une couche mince d'oxyde isolant sur la couche de canal, et sur cette couche mince d'oxyde on dispose un réseau de grilles de transfert étendues perpendiculairement aux zones d'isolement, caractérisé en ce que, sur le substrat, on dépose par épitaxie une première partie d'une couche de base de premier type moins dopée que le substrat, on implante dans la première partie de couche de base, et suivant un motif de colonnes étroites parallèles aux zones d'isolement prévues, à basse énergie un premier dopant de second type, puis, à haute énergie, un second dopant de premier type de sorte que, par diffusion ultérieure, le second dopant diffuse plus profondément que le premier dans la première partie de la couche de base, et on dépose par épitaxie une seconde partie de la couche de base sur la première, avant de former la couche de canal.

Des caractéristiques secondaires et les avantages de l'invention ressortiront d'ailleurs de la description qui va suivre, à titre d'exemple, en référence aux dessins annexés dans lesquels :

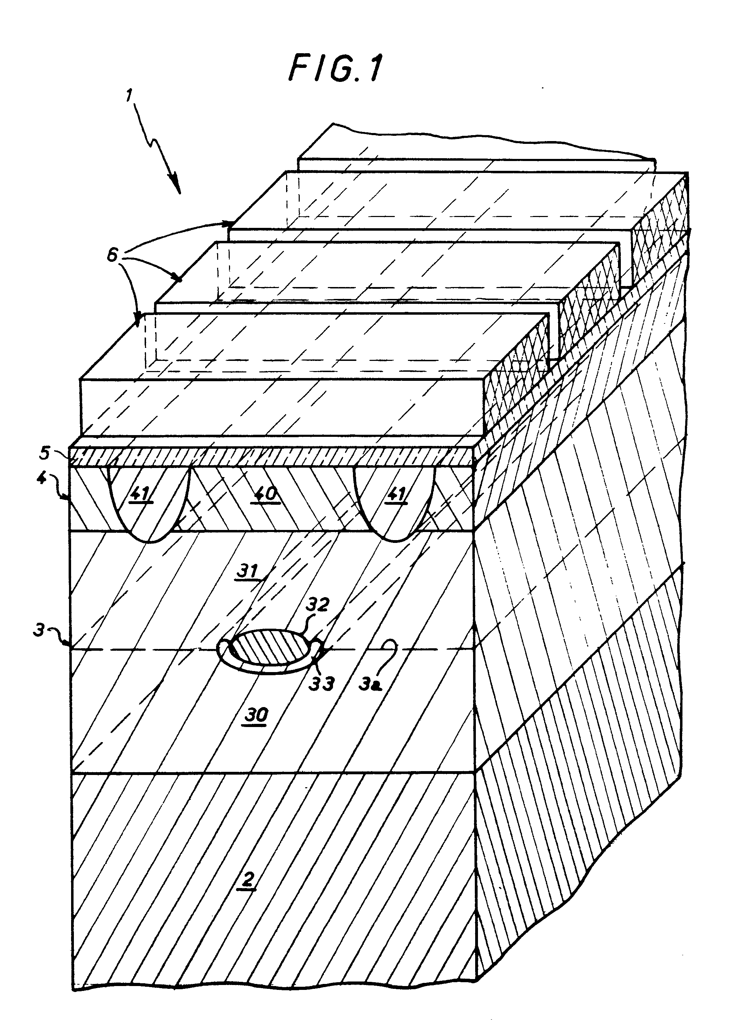

la figure 1 est une perspective d'une matrice selon l'invention, sectionnée sur l'étendue d'un pixel environ ;

la figure 2 est une coupe schématique d'une matrice selon l'invention, représentant la conversion de photons en paires électron-trou, et l'accumulation des charges.

Selon la forme de réalisation choisie et représentée, la matrice 1 dans son ensemble, comporte un substrat 2 en silicium de type P moyennement dopé. Sur le substrat 2 est disposée une couche épitaxiée 3 de type P mais faiblement dopée (de l'ordre de $10^{15}$ atomes par cm$^3$), d'environ 15 µm d'épaisseur, qui sera dite ci-après couche de base. Sur cette couche de base 3 est disposée une couche de canal 4, de type N, surmontée d'une couche d'isolement en oxyde de silicium 5.

La couche de canal 4 est divisée en une pluralité de colonnes 40 par un réseau de zones d'isolement 41, étroites et parallèles, ici obtenues par diffusion d'un dopant de type P, de concentration intermédiaire entre celles du substrat 2 et de la couche de base 3. Par zones étroites, on entend des zones dont la largeur est nettement inférieure à celle des colonnes adjacentes 40.

Au-dessus de la couche d'oxyde 5 est disposé un réseau de grilles 6, étroites, équidistantes et perpendiculaires aux zones d'isolement, réalisées en silicium polycristallin. Ces grilles, convenablement polarisées, divisent les colonnes 40 en une multiplicité de pixels, ou éléments de formation d'images, en induisant des murs de potentiels dans la zone photosensible constituée par la jonction PN de la couche de base 3 et de la couche de canal. Ces murs de potentiels croisent ceux qui sont formés par les zones d'isolement 41, et définissent en coopération avec ces derniers une matrice de puits de potentiels discrets en déplétion, où les porteurs minoritaires, ici des électrons issus de la création, par absorption d'un photon, d'une paire électron-trou dans la région photosensible, peuvent s'accumuler.

On notera que l'épaisseur de cette région, constituée essentiellement par la couche de base, est suffisante pour absorber de façon sensiblement uniforme les photons, quelles que soient leurs longueurs d'ondes dans le spectre utile. Les photons bleus sont absorbés pratiquement sur une courte distance, tandis que les photons rouges ou du proche infrarouge pénètrent nettement plus profondément dans le silicium.

Pour former un signal d'image, on transfère après une période d'accumulation à périodicité de trame, en parallèle pour la pluralité de colonnes, et en série pour les pixels d'une même colonne, les charges accumulées vers une pluralité de capacités de conversion. Ce transfert s'opère par une modulation périodique appropriée des potentiels des grilles, pour déplacer pas à pas en alternance les murs aval et amont de chaque puits dans la direction de la capacité de conversion de la colonne. Les expressions de murs aval et amont se réfèrent au sens de transfert des charges vers la capacité de conversion.

Toutes les dispositions précédentes sont classiques.

Il est également classique, comme il a été rappelé précédemment, de munir les éléments d'image, où s'accumulent les charges, de dispositifs d'anti-éblouissement, constitués par des diodes convenablement disposées et polarisées à partir d'une source de tension, pour devenir passantes lorsque le potentiel créé par la charge d'espace accumulée dans un puits approche le potentiel des crêtes de murs ou parois qui délimitent ce puits, et ainsi drainer vers la source de tension les charges en excès, avant qu'elles ne débordent dans les puits adjacents.

Selon l'invention, des diodes 32 sont disposées enterrées dans la couche de base 3 à un niveau 3a intermédiaire entre ceux des interfaces avec le substrat 2 et avec la couche de canal 4, en pratique à 5-10 µm du substrat 2 et 5-10 µm de la couche de canal.

Ces diodes sont constituées d'un drain étroit 32 de type N assez fortement dopé, allongé parallèlement aux zones d'isolement 41 et à égale distance de celles-ci, et donc sensiblement à l'aplomb du centre de la colonne qu'il dessert. Le drain 32 repose sur un écran 33, constitué par du matériau de type P fortement dopé, de façon que les électrons issus de paires électron-trou formées en dessous du niveau 3a (en majorité des photons rouges et infrarouges) et plus spécialement sous le drain 32, puissent diffuser vers le puits de potentiel situé au-dessus sans être attirés et absorbés par le drain 32.

Comme on le verra plus en détail plus loin, la couche de base 3 est épitaxiée en deux temps. Dans un premier temps, on fait croître par épitaxie une demi-couche inférieure 30, sur laquelle on forme par implantation ionique et diffusion les drains 32 et les écrans 33, puis dans un deuxième temps, on fait croître par épitaxie à partir du niveau 3a une demi-couche supérieure 31.

Les drains 32 sont reliés à la surface de la matrice, au-delà de sa face utile, par des puits collecteurs de type N fortement dopés.

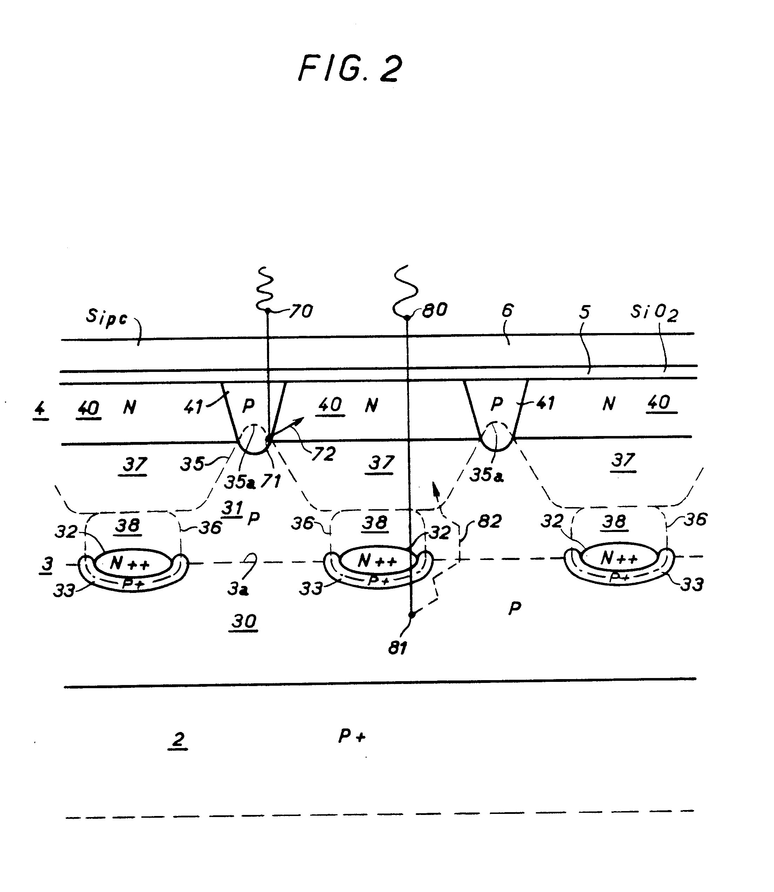

Comme on le verra mieux sur la coupe de la figure 2, la charge d'espace formée par la jonction PN entre la couche de base de type P et la couche de canal 4 de type N, en coopération avec les zones d'isolement 41 de type P, amène la formation d'une équipotentielle 35, qui présente des crêtes 35a dans les zones d'isolement, et détermine, sous les colonnes de la couche de canal 4, la formation de puits 37. On notera que, pendant la période d'accumulation, la polarisation périodique (ici dans l'espace) de grilles du réseau 6 induit la formation de parois, parallèles au plan de figure, avec une configuration de crête analogue aux crêtes 35a.

En outre, la polarisation des drains d'anti-éblouissement 32, conjointement avec la jonction entre drain 32 et écran 33, détermine la formation d'équipotentielles tubulaires 36, qui délimitent des zones de captage 38.

Lorsqu'un photon de courte longueur d'onde (bleu) 70 se trouve absorbé, à une profondeur voisine de celle de la couche de canal, en 71 par exemple, avec formation d'une paire électron-trou, le trou est dilué dans la masse des trous porteurs majoritaires en région P, tandis que l'électron 72 vient diffuser dans le puits proche 37.

Par ailleurs, lorsqu'un photon de grande longueur d'onde 80 (rouge ou infrarouge) est absorbé en profondeur dans la couche de base 3, par exemple en 81, l'électron libéré 82 diffuse dans un trajet déterminé dans son ensemble par le champ entre le substrat 2 et l'équipotentielle 35, altéré localement par la présence de l'écran protecteur 33, les collisions élastiques causant des accidents aléatoires de trajectoire.

On appréciera que, en comparaison avec les systèmes d'anti-éblouissement connus de genre horizontal, pratiquement toute la surface de la matrice est photosensible, aucune partie de la surface n'étant aveuglée par la présence de diode d'anti-éblouissement. L'utilisation de zones d'isolement obtenues par dopage P de la couche de canal de type N, elle aussi photosensible, est de ce point de vue préférable à l'exécution de zones d'isolement de genre dit "LOCOS", obtenues par une oxydation localisée, ou la création d'une zone d'isolement par polarisation d'une grille étendue parallèlement à la colonne.

Et, en comparaison avec les systèmes d'anti-éblouissement du genre vertical, la réponse spectrale du semiconducteur est sensiblement conservée, la profondeur de la couche de base 3 n'étant pas limitée par la profondeur réalisable de caissons de type P dans un substrat N.

Comme on l'a vu, la présence d'écrans protecteurs 33 permet l'utilisation sensiblement complète des tranches profondes de la couche de base 3.

Par ailleurs, les drains 32 pourraient être situés sous les zones d'isolement 41, et l'on pourait envisager qu'il n'existe qu'un drain 32 pour deux zones d'isolement 41, ce drain 32 venant alors écouler les charges des puits de potentiel des deux colonnes 40 adjacentes. Cependant la disposition décrite ici est préférable, avec le drain au plus près de la zone de potentiel extremum.

Pour réaliser une matrice selon l'invention, on prend un substrat 2, de type P et de taux de dopage usuel pour la réalisation de matrices photosensibles (quelques $10^{18}$ atomes par $cm^3$).

On fait croître par épitaxie une demi-couche 30 de type P peu dopé ($10^{15}$ atomes par $cm^3$ environ) sur

une épaisseur de cinq à dix micromètres ; on oxyde la demi-couche 30 sur une profondeur de 0,4 μm environ, on enlève la couche d'oxyde formée aux emplacements des diodes colonnes par photogravure, on effectue une implantation ionique d'antimoine à forte dose (quelques $10^{15}$ atomes par $cm^2$) et faible énergie (les expressions fortes doses et faible énergie doivent s'entendre au sens usuel que leur donne un homme du métier), puis une implantation ionique à haute énergie de bore, de telle sorte que le bore se trouve situé dans l'ensemble sous l'antimoine. Les traitements à haute température ultérieurs de la matrice assureront la diffusion des dopants et l'obtention de la structure de diode 32 avec son écran 33.

Après implantation, on effectue une nouvelle oxydation, dans le but de marquer les diodes et permettre un alignement des colonnes de matrice, puis on enlève tout l'oxyde.

On fait alors croître, sur la surface 3a de la première demi-couche, une seconde demi-couche 31 de type P de même taux de dopage que la première, sur une épaisseur de 5-10 micromètres. L'épaisseur de la demi-couche 31 est réglée en fonction de la tension à appliquer aux drains 32 d'anti-éblouissement.

Après cela on forme, à la surface de la couche de base 3, la couche de canal 4, de type N (quelques $10^{16}$ atomes par $cm^3$), et, dans cette couche de canal, les zones d'isolement 41, repérées par rapport aux emplacements des drains 32.

On fait croître une couche isolante d'oxyde 5, d'épaisseur classique, et on forme le motif du réseau de grilles 6 en silicium polycristallin, transparent pour le spectre utile dans les épaisseurs pratiquées.

On pratique alors des puits de connexion, dans des parties de la matrice extérieures à la surface de formation d'image. Ces puits de connexion sont obtenus par diffusion de phosphore jusqu'au niveau 3a.

Bien entendu, l'invention n'est pas limitée à l'exemple décrit de structure préférée, mais en embrasse toutes les variantes d'exécution, dans le cadre des revendications.

Notamment, l'invention a été décrite en partant d'un substrat de type P, d'une couche de base de type P⁻ et d'une couche de canal de type N, les charges accumulées étant des électrons. Mais il va de soi que l'on pourrait inverser le type de semiconducteur pour tous les éléments de la matrice et obtenir un fonctionnement physiquement correspondant, les charges accumulées étant alors des trous. Toutefois la structure décrite reste préférée, en raison notamment des caractères de mobilité supérieurs des électrons.

## Revendications

1. Matrice photosensible (1) à analyse de trame par transfert de charges, dotée de moyens d'anti-éblouissement de genre vertical, avec, sur un substrat (2) semiconducteur de premier type, une couche de canal (4) de second type séparée par des zones étroites (41) d'isolement en une pluralité de colonnes (40) et surmontée, avec interposition d'une couche mince d'oxyde isolant (5), d'un réseau (6) de grilles de transfert étendues perpendiculairement aux zones d'isolement (41) et divisant les colonnes en une multiplicité de "pixels", caractérisée en ce que les moyens d'anti-éblouissement sont des diodes (32) enterrées dans une couche de base (3) intermédiaire entre le substrat (2) et la couche de canal (4), de premier type et moins dopées que le substrat (2), ces diodes étant disposées en colonnes parallèles aux zones d'isolement (41) et comportant un drain (32) étroit de second type, fortement dopé.

2. Matrice selon la revendication 1, caractérisée en ce que chaque diode comporte encore en écran de protection (33), de premier type et plus dopé que la couche de base (3), disposé adjacent au drain (32) du côté du substrat (2).

3. Matrice selon la revendication 1, caractérisée en ce que chaque colonne (40) de la pluralité est dotée d'une diode d'anti-éblouissement (32).

4. Matrice selon la revendication 3, caractérisée en ce que, en plan, les diodes (32) sont disposées entre les zones d'isolement (41).

5. Matrice selon la revendication 1, caractérisée en ce que les diodes (32) sont enterrées à une profondeur (3a) de l'ordre de la moitié de l'épaisseur de la couche de base (3).

6. Matrice selon la revendication 1, caractérisée en ce que lesdites zones d'isolement (41) sont constituées par du semiconducteur de premier type, avec un dopage intermédiaire entre ceux de la couche de base et du substrat.

7. Matrice selon la revendication 1, caractérisée en ce que le premier type de semiconducteur est P.

8. Procédé de fabrication d'une matrice photosensible (1) à analyse de trame par transfert de charge, dotée de moyens d'anti-éblouissement du genre vertical, où, sur un substrat (2) semiconducteur d'un premier type, on forme une couche de canal (4) de second type en ménageant des zones étroites (41) d'isolement pour diviser la couche de canal (4) en une pluralité de colonnes (40), on forme une couche mince d'oxyde (5) isolant sur la couche de canal, et sur cette couche mince d'oxyde (5), on dispose un réseau (6) de grilles de transfert étendues perpendiculairement aux zones d'isolement (41), caractérisé en ce que, sur le substrat (2), on dépose par épitaxie une première partie (30) d'une couche de base (3) de premier type moins dopée que le substrat, on implante dans la première partie de couche de base, et suivant un motif de colonnes étroites (32) parallèles aux zones d'isolement prévues, à basse énergie un premier dopant de second type, puis, à haute énergie, un second dopant de premier type de sorte que, par diffusion ultérieure, le second dopant diffuse plus profondément que le premier dans la première partie de la couche de base (30), et on dépose par épitaxie une second partie (31) de la couche de base sur la première, avant de former la couche de canal (4).

## FIG.1

# FIG. 2

# DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | US-A-4 697 329 (A.J.J. BOUDEWIJNS) * Figures 1,2; colonne 4, lignes 34-50 * --- | 1,3,4,6 ,7 | H 01 L 27/14 H 04 N 3/15 H 01 L 21/82 |
| A | US-A-3 896 485 (J.M. EARLY) * Figures 1,2; colonne 2, ligne 67 - colonne 4, ligne 29 * --- | 1,5,7 | |
| A | PATENT ABSTRACTS OF JAPAN, vol. 6, no. 226 (E-141)[1104], 11 novembre 1982, page 137 E 141; & JP-A-57 129 582 (NIPPON DENKI K.K.) 11-08-1982 * Figures 1,3,4,5 * ----- | 1,3,4 | |

DOMAINES TECHNIQUES RECHERCHES (Int. Cl.4)

H 01 L
H 04 N

Le présent rapport a été établi pour toutes les revendications

| Lieu de la recherche | Date d'achèvement de la recherche | Examinateur |
|---|---|---|
| LA HAYE | 10-08-1989 | CARDON A. |